# DEMANDE DE BREVET EUROPEEN

(11) **EP 2 541 182 A1**
(43) Date de publication de la demande: **02.01.2013**
(21) Numéro de dépôt: 12173130.1
(22) Date de dépôt: 22.06.2012
(51) Int. Cl.: F28F 1/36, H01L 35/30, F28F 13/12

(54) **Module et dispositif thermo électriques, notamment destinés à générer un courant électrique dans un véhicule automobile.**

(30) Priorité: 30.06.2011 FR 1155875
(71) Demandeur: Valeo Systèmes Thermiques, 78321 Le Mesnil Saint Denis Cedex (FR); Simonin, Michel, 78960 Voisins le Bretonneux (FR)
(72) Inventeur: Simonin, Michel, 78960 VOISINS LE BRETONNEUX (FR)
(74) Mandataire: Gevers France

(57) **Abrégé**

L'invention concerne un module thermo électrique comprenant un canal (8) de circulation d'un premier fluide, dit chaud, et/ou un canal (7) de circulation d'un second fluide, dit froid, et une pluralité d'élément thermo électriques (3), susceptibles de générer un courant électrique sous l'action d'un gradient de température exercé entre deux de leurs faces, dites faces de contact, lesdits faces de contact étant au contact dudit canal (8) de circulation du fluide chaud et/ou dudit canal (7) de circulation du fluide froid.

Selon l'invention, le et/ou lesdits canaux (7, 8) de circulation du fluide chaud et/ou froid sont munis d'un perturbateur (50) permettant de faire varier la vitesse du fluide chaud et/ou froid le long du ou desdits canaux (7, 8).

L'invention concerne également un dispositif thermo électrique, comprenant un tel module.

## Description

La présente invention concerne un module et un dispositif thermo électriques, notamment destinés à générer un courant électrique dans un véhicule automobile.

Dans le domaine automobile, il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Des tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

Les éléments thermo électriques connus sont de forme parallélépipédique rectangle et le gradient de température permettant de générer le courant électrique attendu est imposé entre deux de leurs faces opposées. Il s'agit donc de faces de même dimension.

Or, les coefficients d'échanges thermiques par convection entre un fluide et la paroi d'un tube dans le cas respectivement d'un liquide et d'un gaz sont très différents. L'efficacité thermique de l'ensemble est ainsi limitée par le fluide, ici les gaz d'échappement, présentant le plus faible coefficient d'échange thermique.

Une première solution pour résoudre ce problème est d'utiliser des turbulateurs en métal qui ont pour fonction d'augmenter la surface conductrice de la chaleur au contact des gaz d'échappement et le coefficient d'échange avec lesdits gaz. Mais une telle solution présente des limites car les turbulateurs employés sont des pièces de forme complexe, nécessitant l'utilisation d'outils de découpe et d'emboutissage coûteux.

L'invention se propose d'améliorer la situation et concerne à cet effet un module thermo électrique comprenant un canal de circulation d'un premier fluide, dit chaud, et/ou un canal de circulation d'un second fluide, dit froid, et une pluralité d'élément thermo électriques, susceptibles de générer un courant électrique sous l'action d'un gradient de température exercé entre deux de leurs faces, dites faces de contact, lesdits faces de contact étant au contact dudit canal de circulation du fluide chaud et/ou dudit canal de circulation du fluide froid. Selon l'invention, le et/ou lesdits canaux de circulation du fluide chaud et/ou froid sont munis d'un perturbateur permettant de faire varier la vitesse du fluide chaud et/ou froid le long du ou desdits canaux.

On peut ainsi adapter le coefficient d'échange et améliorer la performance des dispositifs équipés tout en limitant leur coût.

Selon un aspect de l'invention, le perturbateur est configuré pour donner au fluide chaud et/ou froid une trajectoire hélicoïdale. Il est ainsi prévu, notamment, en forme d'hélice. Une telle forme est particulièrement avantageuse en termes de simplicité de réalisation et des effets d'accélération du fluide qu'elle permet, notamment par l'intermédiaire de l'adaptation du pas de ladite hélice.

Selon un autre aspect de l'invention, le perturbateur est prévu dans le canal de circulation du fluide chaud. Il jouera alors son rôle d'adaptation du coefficient d'échange de façon d'autant plus efficace, en particulier en cas de fluide chaud gazeux.

Selon un autre aspect de l'invention, l'une, dite première, desdites faces des éléments thermo électriques est de surface supérieure à l'autre, dite seconde, et ledit module est configuré pour établir un échange thermique entre ladite première face et le fluide chaud et pour établir un échange thermique entre ladite seconde face et le fluide froid, ledit fluide froid présentant un coefficient d'échange thermique supérieur à celui dudit fluide chaud.

En utilisant une surface d'échange plus grande au niveau du fluide présentant le coefficient d'échange le plus faible, il est possible de disposer d'un rapport entre la résistance thermique côté fluide chaud et la résistance thermique côté fluide froid plus équilibré, en particulier en cas d'utilisation d'un fluide chaud gazeux et d'un fluide froid liquide. On améliore de la sorte les résultats déjà amené par le perturbateur.

Selon différents modes de réalisation de cet aspect de l'invention, qui pourront être pris ensemble ou séparément :
- les éléments thermo électriques sont en forme d'anneau ou de portion d'anneau, la première surface étant définie par une surface de périphérie extérieure des anneaux et la seconde surface étant définie par une surface de périphérie intérieure des anneaux,
- lesdites première et/ou seconde surfaces sont générées par une droite,
- lesdites première et/ou seconde surfaces sont de forme cylindrique,
- la première surface présente un rayon compris entre 1,5 et 4 fois le rayon de la seconde surface,
- lesdites première et/ou seconde surfaces sont coaxiales,
- lesdits éléments thermo électriques présentent deux faces planes parallèles opposées,
- lesdits éléments thermo électriques sont de forme et de dimension identiques,
- lesdits éléments thermo électriques sont disposés les uns par rapport aux autres de façon à ce que leur première et/ou seconde surface soient dans le prolongement l'une de l'autre,
- lesdits éléments thermo électriques sont de deux types, un premier type, dit P, permettant d'établir une différence de potentiel électrique entre lesdites première et deuxième faces, lorsqu'ils sont soumis à un gradient de température donné, et d'un second type, dit N, permettant la création d'une différence de potentiel électrique dans un sens opposé entre lesdites première et deuxième faces, lorsqu'ils sont soumis au même gradient de température,
- lesdits éléments thermo électriques sont disposés dans le prolongement longitudinal l'un de l'autre et les éléments thermo électriques de type P alternent avec les éléments thermo électriques de type N,
- les éléments thermo électriques sont groupés par paires, formées d'un dit élément thermo électrique de type P et d'un dit élément thermo électrique de type N, ledit module étant configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine,
- le ou lesdits canaux de circulation du fluide froid sont circulaire et le canal de circulation du fluide chaud est annulaire, lesdits éléments thermo électriques étant disposés radialement entre le canal de circulation du fluide froid, d'une part, et le canal du fluide chaud, d'autre part,
- ledit module comprend une enveloppe externe isolante définissant une paroi externe du canal de circulation du fluide chaud, notamment une enveloppe permettant une isolation thermique entre des gaz d'échappement et l'air ambiant.

L'invention concerne également un dispositif thermo électrique comprenant une pluralité de modules tels que décrit plus haut.

Selon différents aspects de l'invention pris ensemble ou séparément :
- ledit dispositif comprend un corps présentant une pluralité de logements accueillant lesdits modules,
- ledit corps est en matériau réfractaire, isolant et/ou alvéolaire,
- ledit corps est revêtu d'une enveloppe externe anti-choc.

L'invention sera mieux comprise à la lumière de la description suivante qui n'est donnée qu'à titre indicatif et qui n'a pas pour but de la limiter, accompagnée des dessins joints parmi lesquels :
- la figure 1 illustre de façon schématique, selon un plan de coupe axiale, un exemple de module conforme à l'invention,
- les figures 2a à 2e illustre de façon schématique, en perspective, les différentes étapes de montage d'un exemple de module conforme à l'invention,
- la figure 3 illustre de façon schématique la circulation du fluide chaud dans le module de la figure 2e,
- la figure 4 illustre de façon schématique en perspective le corps d'un exemple de dispositif conforme à l'invention,
- la figure 5 illustre le corps de la figure 4 muni de modules selon la figure 2e.

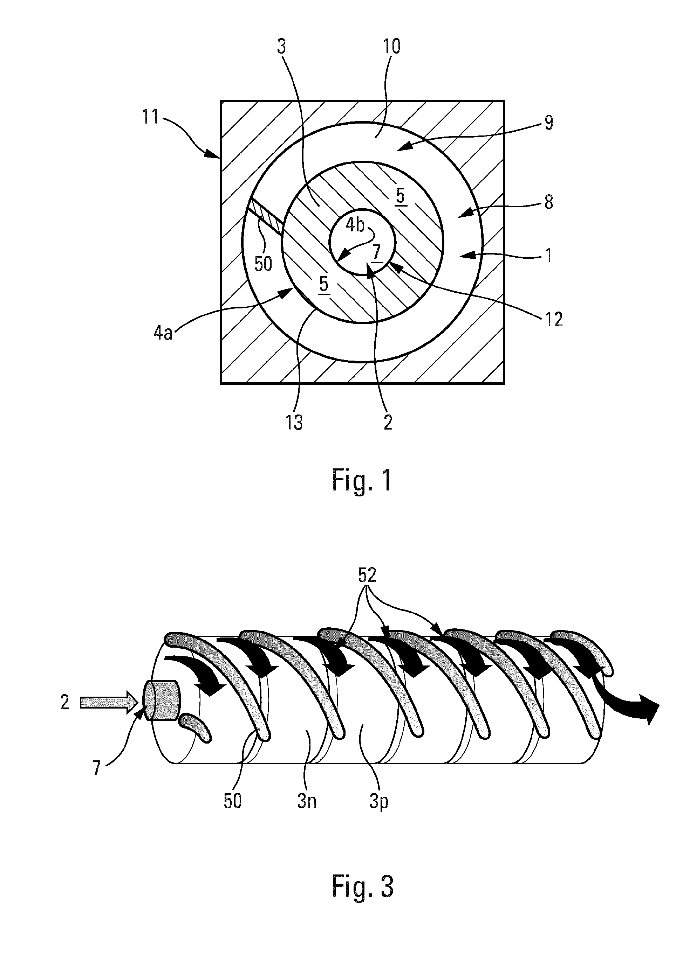

Comme illustré aux figures 1 à 3, l'invention concerne un module thermo électrique, comprenant un premier circuit 1, dit chaud, apte à permettre la circulation d'un premier fluide, dit chaud, notamment des gaz d'échappement d'un moteur, et un second circuit 2, dit froid, apte à permettre la circulation d'un second fluide, dit froid, notamment un fluide caloporteur d'un circuit de refroidissement, de température inférieure à celle du premier fluide.

Le module comprend également une pluralité d'élément thermo électrique 3, 3p, 3n, susceptibles de générer un courant électrique sous l'action d'un gradient de température exercé entre deux de leurs faces 4a, 4b. De tels éléments fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques sont, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

Ici, l'une 4a, dite première, desdites faces est de surface supérieure à l'autre 4b, dite seconde, et ledit module est configuré pour établir un échange thermique entre ladite première face et le premier fluide et pour établir un échange thermique entre ladite seconde face et le second fluide, ledit second fluide présentant un coefficient d'échange thermique supérieure audit premier fluide.

On favorise ainsi l'échange entre les éléments thermo électriques 3p, 3n, et le fluide présentant le coefficient d'échange thermique le plus faible, ici, les gaz d'échappement.

On décrit dans la suite un exemple d'élément thermo électrique équipant le module conforme à l'invention.

Ses dites première 4a et/ou seconde 4b surfaces sont, par exemple, générées par une droite. Cela facilitera la configuration des circuits de fluide 1, 2. Elles sont ainsi, notamment, de forme cylindrique.

On pourra en particulier utiliser un élément thermo électrique en forme d'anneau ou de portion d'anneau, la première surface 4a étant définie par une surface de périphérie extérieure de l'anneau tandis que la seconde surface 4b est définie par une surface de périphérie intérieure de l'anneau.

La première surface 4a présente, par exemple, un rayon compris entre 1,5 et 4 fois le rayon de la seconde surface 4b. Il pourra s'agir d'un rayon égal à environ 2 fois celui de seconde surface 4b.

Pour faciliter l'homogénéité de l'échange thermique angulairement le long des éléments thermo électriques, lesdites première et/ou seconde surfaces 4a, 4b sont, par exemple coaxiales. Autrement dit, les éléments thermo électriques sont muni d'une épaisseur radiale constante.

Lesdits éléments thermo électriques présentent, par exemple, deux faces planes 6a, 6b parallèles opposées. Autrement dit, l'anneau constituant les éléments thermo électriques est de section annulaire rectangulaire.

On décrit dans la suite l'association des éléments thermo électriques entre eux dans le module conforme à l'invention.

Lesdits éléments thermo électriques 3p, 3n sont disposés, par exemple, dans le prolongement longitudinal l'un de l'autre, notamment de façon coaxiale, et les éléments thermo électriques de type P alternent avec les éléments thermo électriques de type N, selon une direction D. Autrement dit, ils forment un empilement selon ladite direction D. Ils sont, notamment, de forme et de dimension identiques.

Lesdits éléments thermo électriques 3p, 3n sont, par exemple, groupés par paire, chaque paire étant formée d'un dit élément thermo électrique de type P et d'un dit élément thermo électrique de type N, et ledit module est configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine. On assure de la sorte une circulation en série du courant électrique entre les éléments thermo électriques 3p, 3n disposés les uns à côtés des autres selon la direction D.

Lesdits éléments thermo électriques 3p, 3n sont disposés les uns par rapport aux autres de façon à ce que leur première et/ou seconde surface 4a, 4b soient dans le prolongement l'une de l'autre. Lesdites première et/ou seconde surfaces 4a, 4b sont ainsi inscrites, par exemple, dans une surface générée par une droite.

Pour la circulation des fluides, le module conforme à l'invention comprend un canal 7 de circulation du fluide froid au contact de ladite seconde surface 4b desdits éléments thermo électriques 3p, 3n et/ou un canal 8 de circulation du fluide chaud au contact de ladite première surface 4a desdits éléments thermo électriques 3p, 3n.

Le ou lesdits canaux 7 de circulation de fluide froid sont, par exemple, de section circulaire. Ledit canal 8 de circulation de fluide chaud est, par exemple de section annulaire. Lesdits éléments thermo électriques 3p, 3n sont disposés entre lesdits canaux 7, 8, par exemple, radialement.

Ledit canal 7 de circulation de fluide froid et ledit canal 8 de circulation de fluide chaud sont, par exemple, coaxiaux.

Afin de le protéger et de l'isoler de l'extérieur, le module conforme à l'invention pourra comprendre une enveloppe externe isolante 11, définissant éventuellement une paroi externe du canal 8 de circulation de fluide chaud.

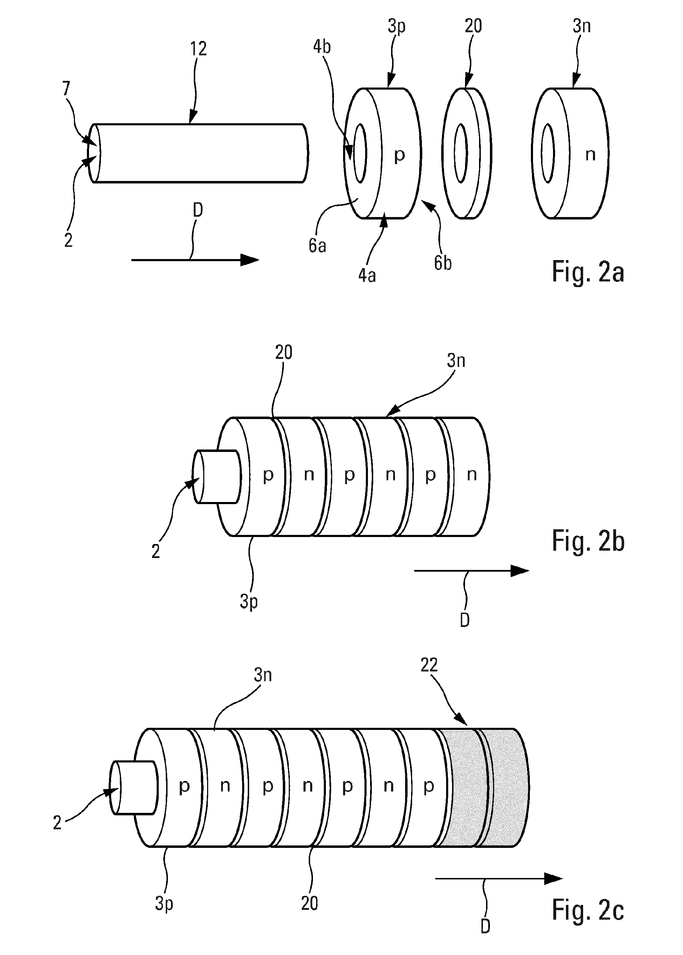

Ici, le module conforme à l'invention comprend un tube 12 de circulation du fluide froid sur lequel sont montés au moins deux éléments thermo électriques du même type alternant selon la direction d'extension longitudinale D du tube avec un éléments thermo électriques de l'autre type. En l'occurrence, comme cela ressort des figures 2b à 2e, une pluralité d'éléments thermo électriques 3p alterne avec une pluralité d'éléments thermo électriques 3n.

Si l'on se rapporte à la figure 2a, on constate qu'une rondelle 20, électriquement isolante, pourra être disposée entre deux faces 6a, 6b en vis-à-vis d'éléments thermo électriques voisins 3p, 3n selon la direction d'extension D longitudinale du tube 12. A la figure 2b, les éléments thermo électriques 3p, 3n, et les rondelles 20 sont assemblés, de façon alternée, sur le tube 12 de circulation de fluide froid.

Comme illustré à la figure 2c, les éléments thermo électriques 3p, 3n sont, par exemple, revêtus deux à deux d'une couche 22 de matière électriquement conductrice, notamment en cuivre et/ou en nickel.

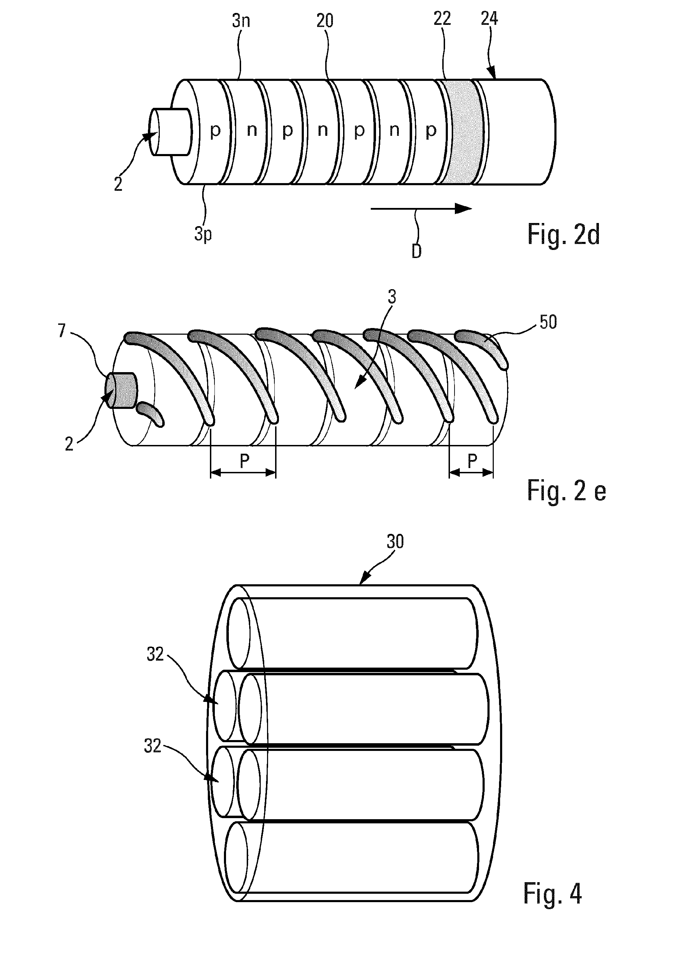

Comme illustré à la figure 2d, les éléments thermo électriques 3p, 3n sont aussi revêtus, par exemple, d'une couche 24 de matériau, isolante électriquement et conductrice thermiquement, définissant au moins en partie une paroi intérieure du canal 8 de circulation de fluide chaud. Il s'agit, notamment, d'un matériau céramique. Ladite couche 24 de matière isolante électriquement et conductrice thermiquement est située au dessus de la couche 22 de matière électriquement conductrice

Le tube de circulation du fluide froid 12 est, notamment, métallique. Il est revêtu, par exemple, d'une fine couche de matériau, par exemple céramique, assurant une conduction thermique et une isolation électrique entre le tube et les éléments thermo électriques 3p, 3n. Pour la conduction électrique entre les éléments thermo électriques 3p, 3n, ladite couche de matériau pourra être revêtue de pistes électriques, notamment dans le but d'assurer une connexion en série des éléments thermo électriques le long de la direction D.

Cela étant, selon l'invention, le et/ou lesdits canaux 7, 8 de circulation du fluide chaud et/ou froid sont munis d'un perturbateur 50 permettant de faire varier la vitesse du fluide chaud et/ou froid le long du ou desdits canaux 7, 8, notamment de la faire augmenter ou diminuer. On adapte de la sorte le coefficient d'échange avec une solution dont la mise en oeuvre est particulièrement simple.

Le perturbateur 50 de l'invention présente ainsi une structure permettant d'accélérer ou freiner le fluide chaud et/ou froid le long du ou desdits canaux 7, 8. On comprend ici que le perturbateur 50 présente au moins une portion transversale à la direction d'écoulement du fluide chaud et/ou froid lorsqu'il pénètre dans le dispositif, c'est-à-dire une portion transversale à la direction D. Autrement dit, le perturbateur comprend une portion transversale à une direction parallèle à un axe défini par la forme annulaire des éléments thermo électriques et/ou axe central du module thermo électrique. Ainsi, le perturbateur 50 ne s'étend pas totalement parallèlement à la direction d'écoulement du fluide chaud et/ou froid lorsqu'il pénètre dans le dispositif, c'est-à-dire qu'il ne s'étend pas totalement parallèlement à la direction D.

Comme illustré à la figure 2e, le perturbateur 50 est, par exemple, de forme hélicoïdale. Le pas p d'hélice pourra être variable le long de l'empilement d'éléments thermo électrique 3p, 3n. Il pourra, par exemple, croître ou décroître le long dudit empilement. On contrôle de la sorte la vitesse du fluide chaud tout le long de son écoulement dans le ou les canaux 7, 8, en particulier dans le premier canal 8. De façon complémentaire, le ou lesdits canaux, en particulier le premier canal 8, pourront présenter une épaisseur variable.

En variante, le pas p d'hélice est constant, notamment sensiblement égal à la longueur axial des éléments thermo électriques 3p, 3n, et seul l'épaisseur des canaux de circulation des fluides, en particulier l'épaisseur du canal 8 de circulation du fluide chaud, varie.

Le perturbateur 50 pourra être de section ronde, comme un fil, et/ou annulaire. Il pourra aussi se présenter sous la forme d'une tresse. Il pourra encore s'agir d'un élément découpé présentant une forme plane à la manière d'un copeau.

Le perturbateur 50 est ici prévu dans le canal 8 de circulation du fluide chaud qui, comme déjà dit, pourra être configuré pour permettre la circulation de gaz, en particulier de gaz d'échappement.

Comme illustré à la figure 3, le perturbateur 50 donne ainsi au fluide une trajectoire hélicoïdale, indiquée par les flèches repérées 52.

Selon un premier exemple de réalisation, le module décrit plus haut, en particulier en relation avec la figure 1, est destiné à être utilisé de façon individuelle, le perturbateur 50 étant alors disposé, par exemple, entre ladite enveloppe 11 et la surface interne du canal 8 de circulation du fluide chaud.

Selon autre exemple de réalisation, le module décrit plus haut, en particulier en relation avec les figures 2a à 2e, forme un crayon, destiné à venir s'insérer dans un dispositif thermo électrique.

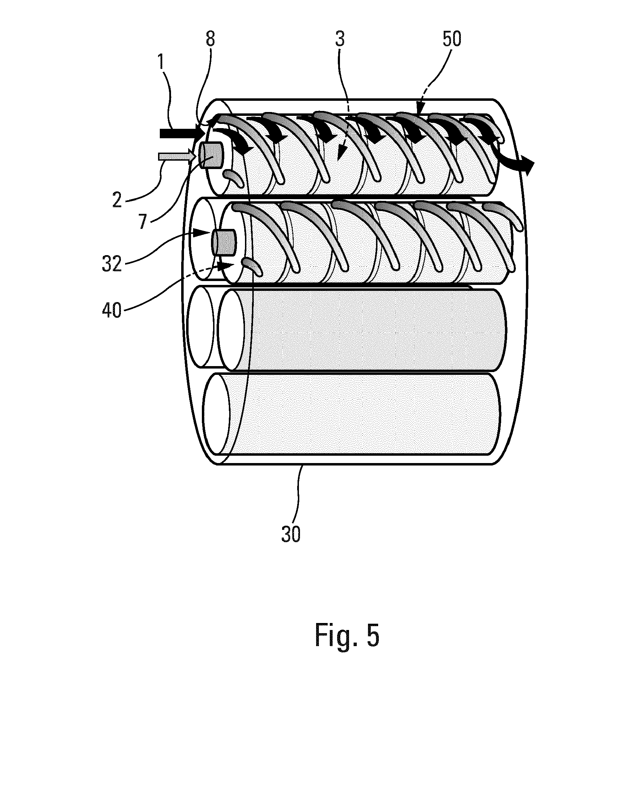

Comme illustré aux figures 4 et 5, l'invention concerne encore d'ailleurs un dispositif comprenant une pluralité de modules thermo électriques.

Ledit dispositif pourra comprendre un corps 30 présentant une pluralité de logements 32 accueillant lesdits modules 40, notamment les modules en forme de crayon tels que ceux déjà évoqués.

Ledit corps 30 est, par exemple, en matériau réfractaire, isolant et/ou alvéolaire.

Les modules 40 pourront être insérés dans lesdits logements 32 et maintenus dans ceux-ci, notamment centrés, à l'aide des perturbateurs 50. La paroi externe du canal 8 de circulation de gaz pourra alors être définie directement par ledit corps 30.

Ledit corps 30 présente, notamment, une configuration sensiblement cylindriques et les logements 32 sont parallèles entre eux et parallèles à l'axe du corps 30. Ils sont, par exemple, régulièrement espacés à sa périphérie.

D'un point de vue électrique, les modules pourront être connectés entre eux en série et/ou en parallèle, par des connexions, non représentées, situées à leurs extrémités longitudinales.

Ledit corps 30 pourra encore être revêtu d'une enveloppe externe anti-choc.

Selon ce qui précède, chaque module est muni d'un canal 7 de circulation de liquide froid unique. En variante, il pourra être prévu plusieurs canaux de circulation du fluide froid, notamment configurés pour être en relation d'échange thermique avec les éléments thermo électriques, prévus alors en forme de portion angulaire d'anneau.

## Revendications

1. Module thermo électrique comprenant un canal (8) de circulation d'un premier fluide, dit chaud, et/ou un canal (7) de circulation d'un second fluide, dit froid, et une pluralité d'éléments thermo électriques (3, 3p, 3n), susceptibles de générer un courant électrique sous l'action d'un gradient de température exercé entre deux de leurs faces, dites faces de contact (4a, 4b), lesdits faces de contact (4a, 4b) étant au contact dudit canal (8) de circulation du fluide chaud et/ou dudit canal (7) de circulation du fluide froid, **caractérisé en ce que** le et/ou lesdits canaux (7, 8) de circulation du fluide chaud et/ou froid sont munis d'un perturbateur (50) permettant de faire varier la vitesse du fluide chaud et/ou froid le long du ou desdits canaux (7, 8).

2. Module selon la revendication 1 dans lequel le perturbateur (50) est configuré pour donner au fluide chaud et/ou froid une trajectoire hélicoïdale.

3. Module selon l'une des revendications 1 ou 2 dans lequel le perturbateur (50) présente une forme en hélice.

4. Module selon la revendication 3 dans lequel l'hélice présente un pas p variable.

5. Module selon l'une quelconque des revendications 1 à 4 dans lequel le perturbateur (50) est prévu dans le canal (8) de circulation du fluide chaud.

6. Module selon l'une quelconque des revendications précédentes dans lequel l'une (4a), dite première, desdites faces des éléments thermo électriques (3, 3p, 3n) est de surface supérieure à l'autre (4b), dite seconde, et ledit module est configuré pour établir un échange thermique entre ladite première face (4a) et le fluide chaud et pour établir un échange thermique entre ladite seconde face (4b) et le fluide froid, ledit fluide froid présentant un coefficient d'échange thermique supérieur à celui dudit fluide chaud.

7. Module selon l'une quelconque des revendications précédentes dans lequel les éléments thermo électriques (3, 3p, 3n) sont en forme d'anneau ou de portion d'anneau, la première surface (4a) étant définie par une surface de périphérie extérieure des anneaux et la seconde surface (4b) étant définie par une surface de périphérie intérieure des anneaux.

8. Module selon l'une quelconque des revendications précédentes dans lequel lesdites première et/ou seconde surfaces (4a, 4b) sont de forme cylindrique.

9. Module selon l'une quelconque des revendications précédentes comprenant une enveloppe externe isolante (11) définissant une paroi externe du canal (8) de circulation du fluide chaud.

10. Dispositif thermo électrique, notamment destiné à générer un courant électrique dans un véhicule automobile, ledit dispositif comprenant une pluralité de modules selon l'une quelconque des revendications 1 à 9 précédentes.
